# EUROPÄISCHE PATENTSCHRIFT

(11) **EP 2 320 243 B1**
(45) Veröffentlichungstag und Bekanntmachung des Hinweises auf die Patenterteilung: **14.12.2011**
(21) Anmeldenummer: 09013981.7
(22) Anmeldetag: 06.11.2009
(51) Int. Cl.: G01R 33/09, G01N 27/74

(54) **Komponente für eine Vorrichtung zur Bestimmung des Anteils an Sauerstoff in einem Gas, Vorrichtung mit einer solchen Komponente, Verwendung eines Magnetfeldsensors sowie Verfahren zur Bestimmung des Anteils an Sauerstoff in einem Gas**
Component for a device for determining the proportion of oxygen in a gas, device with such a component, use of a magnetic field sensor and method for determining the proportion of oxygen in a gas
Composants pour un dispositif de détermination de la part d'oxygène dans un gaz, dispositif doté d'un tel composant, utilisation d'un capteur de champ magnétique et procédé de détermination de la part d'oxygène dans un gaz

(43) Veröffentlichungstag der Anmeldung: 11.05.2011
(73) Patentinhaber: M & C TechGroup Germany GmbH, 40885 Ratingen (DE)
(72) Erfinder: Müller, Jörg, 21073 Hamburg (DE); König, Florian, 21073 Hamburg (DE); Rumm, Hans-Jörg, 46145 Oberhausen (DE); Gatzemann, Andreas, 27383 Scheessel (DE)
(74) Vertreter: Berkenbrink, Kai-Oliver

(56) Entgegenhaltungen:
- WO-A1-2009/037636
- WO-A1-2009/138897
- DE-A1- 19 739 206
- US-A- 4 173 975
- US-A- 4 667 157

## Beschreibung

Die Erfindung betrifft eine Komponente für eine Vorrichtung zur Bestimmung des Anteils an Sauerstoff in einem Gas, eine Vorrichtung mit einer solchen Komponente, die Verwendung eines Magnetfeldsensors sowie ein Verfahren zur Bestimmung des Anteils an Sauerstoff in einem Gas.

Gase unterliegen in einem Magnetfeld einer Magnetisierung. Ein Maß für die Magnetisierung ist die magnetische Suszeptibilität. Die meisten Gase haben eine negative Suszeptibilität und weisen daher ein diamagnetisches Verhalten auf, das heißt, diese Gase werden aus einem inhomogenen Magnetfeld verdrängt und schwächen das Magnetfeld.

Einige wenige Gase, insbesondere Sauerstoff (O₂), Stickoxide (NO, NO₂) und Chlordioxid (ClO₂), weisen hingegen eine positive Suszeptibilität und daher ein paramagnetisches Verhalten auf. Diese Gase werden daher an den Ort größter Feldstärke in das Magnetfeld hineingezogen und verstärken das Magnetfeld.

Die paramagnetischen Eigenschaften dieser Gase eignen sich für die Anwendung physikalischer Messverfahren zur Bestimmung des Anteils an diesen Gasen in einem Gas. Ein wesentlicher Vorteil solcher Verfahren liegt darin, dass keine Stoffe verbraucht werden und keine chemischen Reaktionen stattfinden.

Vorrichtungen zur Bestimmung des Anteils an Sauerstoff und einem Gas, die die paramagnetischen Eigenschaften von Sauerstoff ausnutzen, sind bekannt. Ein Beispiel für entsprechende Vorrichtungen ist die Sauerstoffmessung über ein magnetomechanisches System. Dabei wird ein Sensorelement, das aus stickstoffgefüllten Quarzkugeln in Form einer Hantel besteht, in einem inhomogenen Magnetfeld frei drehend angeordnet. Auf Grund der diamagnetischen Eigenschaft des Stickstoffes wird die Hantel aus ihrer Ruhelage gedreht, wenn das Sensorelement mit einem sauerstoffhaltigen Gas beaufschlagt wird. Die Drehbewegung der Hantel wird optisch detektiert und zur Steuerung eines Stromes verwendet, der mit Hilfe einer Leiterschleife ein Gegenfeld aufbaut und die Hantel in die Ausgangslage zurückversetzt. Die Stromstärke ist dabei ein Maß für die Sauerstoffkonzentration in dem die Hantel beaufschlagenden Gas.

Grundsätzlich hat sich eine solche Vorrichtung zur Bestimmung des Sauerstoffanteils in Gasen zwar bewährt. Nachteilig an dieser Art Vorrichtung ist jedoch, dass sie äußerst kompliziert aufgebaut und daher schwierig zu konfektionieren ist. Ferner zeigt sich die Vorrichtung anfällig für Erschütterungen. Hierdurch kann die Vorrichtung beschädigt werden, so dass eine zuverlässige Sauerstoffmessung nicht mehr gewährleistet ist. Auch kann diese bekannte Vorrichtung für bestimmte Gase, insbesondere einige aggressive Gase, nicht verwendet werden.

WO 2009/138897 A1 offenbart einen Sauerstoffsensor, der ein Magnetfelderzeugungsmittel sowie einen GMR-Sensor umfasst. Bei der in DE 197 39 206 A1 beschriebenen Vorrichtung wird die Sauerstoffkonzentration durch einen Magnetfeldsensor bestimmt, der die Verstimmung des magnetischen Flusses in einer Magnetkreisanordnung bestimmt, wenn diese von Messgut beströmt wird. Bei der in US 4,667,157 offenbarten Vorrichtung wird die Sauerstoffkonzentration durch einen Hall-Effekt-Sensor ermittelt. In DE 29 04 427 A1 wird ein Magnetkreis mit einem Luftspalt beschrieben, in den eine Referenzzelle oszillatorisch eintauchen kann; diese oszillatorische Bewegung variiert den Magnetfluss, wobei die Variation ein Maß für die Sauerstoffkonzentration darstellt.

WO 2009/037636 A1 offenbart eine Vorrichtung zur Untersuchung von chemischen Substanzen, bei der sich ein zu untersuchendes Fluid zusammen mit magnetischen Partikeln in einer Reaktionskammer befindet. Die Reaktionskammer wird mit einem rotierenden magnetischen Feld beaufschlagt, wobei die Rotationsfrequenz höher ist als die kritische Schlupffrequenz der magnetischen Partikel. Zur Untersuchung der chemischen Substanzen misst nunmehr ein Sensorelement den Effekt des rotierenden magnetischen Feldes auf die magnetischen Partikel.

Aufgabe der vorliegenden Erfindung ist es, eine Komponente für eine Vorrichtung zur Bestimmung des Anteils an Sauerstoff in einem Gas, eine damit ausgestattete Vorrichtung sowie ein Verfahren zur Verfügung zu stellen, durch die der Anteil an Sauerstoff in einem Gas zuverlässig bestimmt werden kann.

Eine weitere Aufgabe ist es, eine solche Komponente und Vorrichtung zur Verfügung zu stellen, die möglichst robust sind, so dass sie möglichst wenig fehler- und erschütterungsanfällig sind und insbesondere auch für aggressive Gase eingesetzt werden können.

Ferner ist es eine Aufgabe der vorliegenden Erfindung, eine solche Komponente und Vorrichtung zur Verfügung zu stellen, die einfach aufgebaut und daher auch einfach zu konfektionieren sind.

Zur Lösung dieser Aufgabe wird erfindungsgemäß zunächst eine Komponente für eine Vorrichtung zur Bestimmung des Anteils an Sauerstoff in einem Gas zur Verfügung gestellt, die die Merkmale gemäß Anspruch 1 aufweist.

Ein wesentlicher Grundgedanke der Erfindung liegt demnach darin, wenigstens einen Magnetfeldsensor zur Bestimmung des Anteils an Sauerstoff in einem Gas zu verwenden.

Bei Magnetfeldsensoren, auch magnetoresistive Sensoren genannt, handelt es sich um Sensoren, deren elektrischer Widerstand sich in Abhängigkeit von der Änderung des Magnetfeldes, in dem sich der Sensor befindet, ändert. Die Funktion dieser Sensoren beruht entweder auf dem anisotropen Magnetowiderstandseffekt, dem magnetischen Tunnelwiderstand oder dem Riesen-Magnetowiderstandseffekt. Vorteile dieser Sensoren sind insbesondere, dass die Signalverarbeitung von einer einfachen Elektronik übernommen werden kann und dass sie eine hohe Empfindlichkeit gegenüber Magnetfeldänderungen besitzen.

Sensoren, deren Funktion auf dem anisotropen Widerstandseffekt beruhen, werden auch als AMR-Magnetfeldsensoren bezeichnet ("AMR" für "anisotropic magnetoresistance"). Dieser Effekt beruht auf anisotroper, also von der Raumrichtung abhängiger Streuung in ferromagnetischen Metallen. Der Widerstand des AMR-Magnetfeldsensors ändert sich damit in Abhängigkeit von der Änderung der Richtung des ihn umgebenden Magnetfeldes beziehungsweise der Richtung der magnetischen Flussdichte B des Magnetfeldes, in dem sich der AMR-Magnetfeldsensor befindet. Dabei ist definitionsgemäß die magnetische Flussdichte B ein Vektor in Richtung der magnetischen Feldstärke H eines Magnetfeldes.

Magnetoresisitve Sensoren, deren Funktion auf dem Prinzip des magnetischen Tunnelwiderstandes aufbauen, werden als TMR-Magnetfeldsensoren bezeichnet ("TMR," für "tunnel magnetoresistance"). Auch bei diesen Sensoren ist deren Widerstand abhängig von der Richtung des umgebenden Magnetfeldes.

AMR- und TMR-Magnetfeldsensoren wurden bisher in Leseköpfen für Festplatten eingesetzt. AMR- Magnetfeldsensoren werden zudem für die kontaktlose Positionsmessung eingesetzt.

Überraschend hat sich nunmehr herausgestellt, dass Magnetfeldsensoren auch in hervorragender Weise zur Bestimmung des Anteils von Sauerstoff in Gasen verwendet werden können. Die Grundidee der erfindungsgemäßen Verwendung von Magnetfeldsensoren zur Bestimmung des Anteils an Sauerstoff in einem Gas besteht nunmehr darin, dass wenigstens ein Magnetfeldsensor derart in einem von einem Gas durchströmbaren Magnetfeld angeordnet wird, dass sich der elektrische Widerstand des Magnetfeldsensors in Abhängigkeit von der Änderung des Magnetfeldes, den dieses in Abhängigkeit von dem Anteil an Sauerstoff in dem durch das Magnetfeld geleiteten Gas erfährt, ändert. Diese Änderung des elektrischen Widerstandes des Magnetfeldsensors wird bestimmt und ist ein Maß für den Anteil an Sauerstoff in dem Gas.

Besonders vorteilhaft an der erfindungsgemäßen Komponente ist, dass diese keinerlei bewegliche Teile aufweisen muss. Die Komponente kann damit äußerst robust konfektioniert sein, so dass sie nur eine äußerst geringe Fehleranfälligkeit aufweist und auch zur Messung besonders aggressiver Gase eingesetzt werden kann. Gleichzeitig lässt sich die erfindungsgemäße Komponente gegenüber den aus dem Stand der Technik bekannten Sensoren zur Sauerstoffanalyse, beispielsweise den zuvor beschriebenen Sensoren auf Basis einer drehbaren Hantel, wesentlich einfacher und damit insbesondere auch kostengünstiger konfektionieren.

Es kann vorgesehen sein, dass die erfindungsgemäße Komponente mit den Methoden der Mikrosystemtechnik hergestellt ist. Dies hat den Vorteil, dass die Komponente stark miniaturisiert sein kann, eine hohe Reproduzierbarkeit aufweist und gleichzeitig mit nur geringen Herstellungskosten produziert werden kann.

Grundsätzlich beziehen sich die erfindungsgemäße Komponente, Vorrichtung, Verwendung und das erfindungsgemäße Verfahren auf die Bestimmung des Anteils an beliebigen paramagnetischen Gasen in einem Gas und daher, neben Sauerstoff, beispielsweise auch auf die Bestimmung von Stickoxiden in einem Gas.

Die erfindungsgemäße Komponente zur Bestimmung des Anteils an Sauerstoff in einem Gas weist wenigstens einen der folgenden Magnetfeldsensoren auf: Einen AMR-Magnetfeldsensor oder einen TMR- Magnetfeldsensor.

Die erfindungsgemäße Komponente weist damit jeweils einen oder mehrere dieser Magnetfeldsensoren oder auch eine Kombination dieser Magnetfeldsensoren auf. Soweit nachfolgend daher Ausführungen zur Art oder Anordnung von Magnetfeldsensoren gemacht werden, gelten diese Ausführungen für einen, mehrere oder sämtliche der Magnetfeldsensoren der vorliegenden Erfindung.

Soweit Magnetfeldsensoren in Form von AMR- oder TMR-Magnetfeldsensoren eingesetzt werden, ist wenigstens ein Magnetfeldsensor in Form eines als Vollbrücke ausgebildeten AMR- oder TMR-Magnetfeldsensors eingesetzt. Magnetfeldsensoren in Form eines Vollbrücken-Sensors arbeiten bekanntermaßen nach dem Prinzip einer Wheatstone'schen Brückenschaltung. Der Vorteil eines solchen Vollbrücken-Sensors liegt insbesondere darin, dass bereits eine kleine Widerstandsänderung im Magnetfeldsensor zu einem großen Messeffekt führt.

Erfindungsgemäß hat sich herausgestellt, dass insbesondere AMR- und TMR-Magnetfeldsensoren zur Bestimmung des Anteils an Sauerstoff in einem Gas verwendet werden können, da bereits kleine Sauerstoffanteile in einem Messgas eine durch einen AMR oder TMR-Magnetfeldsensor bestimmbare Richtungsänderung des Magnetfeldes bewirken können.

AMR- und TMR-Magnetfeldsensoren weisen eine so genannte empfindliche Achse auf. Änderungen der Richtung der magnetischen Flussdichte des Magnetfeldes, in dem sich AMR- oder TMR-Magnetfeldsensoren befinden, in Richtung dieser empfindlichen Achse können durch AMR- und TMR-Magnetfeldsensoren gemessen werden. Dabei führt eine Änderung der Richtung der magnetischen Flussdichte des Magnetfeldes, in dem sich der AMR- oder TMR-Magnetfeldsensor befindet, in Richtung der empfindlichen Achse des AMR- oder TMR-Magnetfeldsensors zu einer Änderung seines elektrischen Widerstandes. Diese Widerstandsänderung kann gemessen werden und dient erfindungsgemäß zur Bestimmung des Anteils an Sauerstoff in dem Gas, das durch das Magnetfeld geleitet wurde und dadurch zur Änderung der Richtung der magnetischen Flussdichte führte. Änderungen der Richtung der magnetischen Flussdichte des Magnetfeldes senkrecht zur empfindlichen Achse des AMR- oder TMR-Magnetfeldsensors haben keine Auswirkungen auf dessen Widerstand.

Erfindungsgemäß ist vorgesehen, dass durch die Magnetfelderzeugungsmittel ein Magnetfeld erzeugbar ist, das im Wesentlichen keine magnetische Flussdichte in Richtung der empfindlichen Achse des AMR- oder TMR-Magnetfeldsensors aufweist. Mit anderen Worten: Der AMR- oder TMR-Magnetfeldsensor ist derart angeordnet, dass das Magnetfeld keine magnetische Flussdichte in Richtung der empfindlichen Achse des AMR- oder TMR-Magnetfeldsensors aufweist. Dies gilt selbstverständlich in der "Nullstellung" der erfindungsgemäßen Komponente, also wenn das Magnetfeld nicht durch hindurchgeleitetes Gas verändert wird.

Durch die Magnetfelderzeugungsmittel kann daher - wiederum in Nullstellung der erfindungsgemäßen Komponente - insbesondere ein Magnetfeld erzeugbar sein, dessen Feldrichtung im Wesentlichen senkrecht zur empfindlichen Achse des AMR- oder TMR-Magnetfeldsensors verläuft. Mit anderen Worten: Der AMR- oder TMR-Magnetfeldsensor kann derart angeordnet sein, dass seine empfindliche Achse senkrecht zur Richtung der magnetischen Flussdichte des Magnetfeldes verläuft, in dem sich der AMR- oder TMR-Magnetfeldsensors befindet.

In Nullstellung der Komponente sind Feldrichtung beziehungsweise Richtung der magnetischen Flussdichte des Magnetfeldes einerseits und AMR- oder TMR-Magnetfeldsensor andererseits daher bevorzugt derart zueinander angeordnet, dass die magnetische Flussdichte in Richtung der empfindlichen Achse des AMR- oder TMR-Magentfeldsensors Null beträgt beziehungsweise möglichst gering ist. In der Praxis ist es selbstverständlich nicht möglich, dass die magnetische Flussdichte in Richtung der empfindlichen Achse des AMR- oder TMR-Magnetfeldsensors tatsächlich exakt Null ist. Erfindungsgemäß bedeutete "keine" magnetische Flussdichte in dieser Richtung beziehungsweise eine magnetische Flussdichte von "Null" in einer Richtung daher "so gering wie (technisch) möglich".

Insbesondere kann vorgesehen sein, dass in Nullstellung der erfindungsgemäßen Komponente die magnetische Flussdichte in Richtung der empfindlichen Achse des AMR- oder TMR-Magnetfeldsensors deutlich unterhalb der Empfindlichkeit des AMR- oder TMR-Magnetfeldsensors liegt. Die Empfindlichkeit des AMR- oder TMR-Magnetfeldsensors gibt die Stärke der magnetischen Flussdichte in Richtung der empfindlichen Achse des AMR-oder TMR-Magnetfeldsensors an, innerhalb derer Änderungen der Richtung der magnetischen Flussdichte in Richtung seiner empfindlichen Achse messbar sind. Die Empfindlichkeit heutiger AMR- und TMR-Magnetfeldsensoren liegt regelmäßig unter 100 nT (Nano Teslar) und üblicherweise im Bereich bis etwa 20 nT. Soweit die magnetische Flussdichte des Magnetfeldes in Richtung der empfindlichen Achse des AMR- oder TMR-Magnetfeldsensors entsprechende Werte bereits in der Nullstellung der Komponente übersteigen würde, könnte der AMR- oder TMR-Magnetfeldsensor eine Magnetfeldanderung nicht mehr bestimmen, da er bereits auf Grund des umgebenden Magnetfeldes in der Nullstellung seine Empfindlichkeits- beziehungsweise Messgrenze erreicht hätte. Erfindungsgemäß kann daher vorgesehen sein, dass durch die Magnetfelderzeugungsmitel ein Magnetfeld erzeugbar ist, dessen magnetische Flussdichte in Richtung der empfindlichen Achse des AMR- oder TMR-Magnetfeldsensors unter 50 % und damit beispielsweise auch unter 30 % oder unter 10 % der Empfindlichkeit beziehungsweise Messgrenze des AMR- oder TMR-Magnetfeldsensors liegen. Mit anderen Worten: Der AMR- oder TMR-Magnetfeldsensor ist derart angeordnet, dass die magnetische Flussdichte des Magnetfeldes in Richtung der empfindlichen Achse des AMR- oder TMR-Magnetfeldsensors unter 50 % und damit beispielsweise auch unter 30 % oder unter 10 % seiner Empfindlichkeit beziehungsweise Messgrenze liegen.

Mit zunehmender Stärke des Magnetfeldes nimmt auch die Stärke der Magnetfeldänderung zu, die durch den Anteil an Sauerstoff in dem durch das Magnetfeld geleiteten Gas hervorgerufen wird.

Aus diesem Grunde ist es vorteilhaft, das Gas durch ein möglichst starkes Magnetfeld zu leiten, da eine stärkere Magnetfeldänderung ein höheres und damit deutlicheres Messsignal erwarten lässt. Gleichzeitig wird es mit stärker werdenden Magnetfeldern jedoch zunehmend schwieriger, den Magnetfeldsensor derart im Magnetfeld anzuordnen beziehungsweise auszurichten, dass die magnetische Flussdichte des Magnetfeldes in Richtung der empfindlichen Achse des AMR- oder TMR-Magnetfeldsensors Null ist oder auch nur deutlich unterhalb seiner Empfindlichkeit liegt. Besonders vorteilhaft ist daher die Erzeugung eines Magnetfeldes in einer Stärke, in der einerseits ein guter Messeffekt erzielbar ist, in der andererseits der Magnetfeldsensor aber noch derart anordenbar ist, dass die magnetische Flussdichte des Magnetfeldes in Richtung der empfindlichen Achse des AMR-oder TMR-Magnetfeldsensors nur möglichst gering sind.

Ferner sollte ein Magnetfeld in einer Stärke erzeugbar sein, durch das bei Leitung des Gases durch das Magnetfeld eine Änderung der magnetischen Flussdichte erzeugbar ist, die oberhalb der Auflösungsgrenze, also der unteren Messgrenze, des Magnetfeldsensors liegt. Diese Auflösungsgrenze liegt bei heutigen Magnetfeldsensoren bei etwa 2 nT.

Erfindungsgemäß hat sich herausgestellt, dass in diesem Sinne ein Magnetfeld vorteilhaft ist, das eine Stärke von wenigstens 0,1 mT aufweist, also beispielsweise auch eine Stärke von wenigstens 0,5 mT, 1 mT, 5 mT oder 8 mT. Die Obergrenze des Magnetfeldes liegt erfindungsgemäß bevorzugt nicht über 1000 mT, also beispielsweise auch nicht über 800 mT, 400 mT, 100 mT, 50 mT, 20 mT oder 15 mT. Mit anderen Worten: Durch die Magnetfelderzeugungsmittel der erfindungsgemäßen Komponente ist bevorzugt ein Magnetfeld mit einer Stärke innerhalb der vorgenannten Werte erzeugbar. Die vorbezeichnete Stärke des Magnetfeldes gilt insbesondere für den Bereich des erzeugbaren Magnetfeldes, durch den das Gas geleitet wird beziehungsweise den Bereich, in dem der Magnetfeldsensor angeordnet ist.

Bevorzugt ist vorgesehen, dass durch die Magnetfelderzeugungsmittel zumindest bereichsweise ein homogenes Magnetfeld erzeugbar ist. Insbesondere kann vorgesehen sein, dass durch die Magnetfelderzeugungsmittel wenigstens in dem Bereich, in dem der Magnetfeldsensor angeordnet ist, ein homogenes Magnetfeld erzeugbar ist.

Im Bereich des homogenen Magnetfeldes weist die magnetische Flussdichte des Magnetfeldes nur eine Richtung auf. Die Feldrichtung des homogen erzeugbaren Magnetfeldes kann (in Nullstellung der Vorrichtung), in Fortbildung des oben stehenden Erfindungsgedankens, im Wesentlichen senkrecht zur empfindlichen Achse des AMR- oder TMR-Magnetfeldsensors verlaufen. Wird mittels der Gasführungsmittel nunmehr ein Sauerstoff aufweisendes Gas durch das zunächst homogene Magnetfeld geleitet, ist die Änderung der Richtung der magnetischen Flussdichte des Magnetfeldes sehr einfach durch den AMR- oder TMR-Magnetfeldsensor messbar und der Sauerstoffanteil im Gas damit sehr einfach und zuverlässig bestimmbar.

Bevorzugt ist vorgesehen, dass der Magnetfeldsensor versetzt zu den Gasführungsmitteln angeordnet ist. Insbesondere der AMR- oder TMR-Magnetfeldsensor kann demnach derart angeordnet sein, dass die durch die Mitte der Gasführungsmittel (also deren Längsachse) verlaufenden Feldlinien des Magnetfeldes nicht durch die Mitte der empfindlichen Achse des AMR-oder TMR-Magnetfeldsensors verlaufen. Mit anderen Worten: In Richtung der empfindlichen Achse des AMR- oder TMR-Magnetfeldsensors sind Magnetfeld, Gasführungsmittel und AMR- oder TMR-Magnetfeldsensor asymmetrisch zueinander angeordnet. Durch diese asymmetrische Anordnung ist ausgeschlossen, dass sich Änderungen der Richtung der magnetischen Flussdichte des Magnetfeldes (insbesondere eines homogenen Magnetfeldes) in Richtung der empfindlichen Achse des AMR- oder TMR-Magnetfeldsensors gegenseitig aufheben, so dass eine Widerstandsänderung des Magnetfeldsensors nicht messbar wäre.

Die Gasführungsmittel der Komponente, mittels derer das Gas durch das Magnetfeldes leitbar ist, können grundsätzlich beliebige aus dem Stand der Technik zur Leitung von Gasen bekannte Mittel sein. Beispielsweise können die Gasführungsmittel als Rohr, Schlauch, Kapillare, Kanäle oder Kombinationen hieraus konfektioniert sein. Es kann vorgesehen sein, dass die Gasführungsmittel zumindest in den Bereichen, in denen das Gas in Kontakt mit den Gasführungsmitteln tritt, mit einer Beschichtung versehen sind, insbesondere beispielsweise einer Schutzbeschichtung zum Schutz der Gasfuhrungsmittel vor aggressiven Gasen.

Bevorzugt bestehen die Gasführungsmittel aus einem diamagnetischen Material. Beispielsweise können die Gasführungsmittel aus einem oder mehreren der folgenden Materialien bestehen: Glas, Quarzglas, Silizium, diamagnetischer Kunststoff oder Kombinationen dieser Materialien.

Die Gasführungsmittel können wenigstens einen Gaseinlass zur Einleitung von Gas in die Komponente und wenigstens einen Gasauslass zur Ausleitung von Gas aus der Komponente aufweisen.

Die Gasführungsmittel können einen beliebigen Verlauf aufweisen und beispielsweise linear, winkelig oder geschwungen, beispielsweise U-förmig verlaufen. U-förmig ausgebildete Gasfuhrungsmittel haben den Vorteil, dass der Gaseinlass und der Gasauslass der Gasführungsmittel an derselben Seite der Komponente angeordnet sein können.

Gemäß einem Erfindungsgedanken ist vorgesehen, dass die Gasführungsmittel durch eine Kombination miteinander verbundener Komponenten ausgebildet sind. Nach einer bevorzugten Ausführungsform ist vorgesehen, dass die Gasführungsmittel in einem Stapel aus miteinander verbundenen, beispielsweise miteinander verklebten, Platten angeordnet sind. Diese Platten können insbesondere aus diamagnetischen Materialien bestehen, bevorzugt aus einem oder mehreren der vorbezeichneten, diamagnetischen Materialien. Beispielsweise kann ein Stapel aus wenigstens zwei miteinander verbundenen Platten vorgesehen sein, wobei wenigstens eine der Platten auf ihrer Oberfläche Kanalstrukturen aufweist und diese Oberfläche der ersten Platte durch eine zweite Platte abgedeckt ist. Die Kanalstrukturen sind derart ausgebildet, dass diese nach Abdeckung durch die zweite Platte Gasführungsmittel bilden. Nach einer Fortbildung dieses Erfindungsgedankens kann auch die zweite Platte auf ihrer Oberflächen Kanalstrukturen aufweisen, die sich mit den Kanalstrukturen der ersten Platte zu den Gasführungsmitteln ergänzen.

Nach einer Ausführungsform ist beispielsweise eine erste Platte aus Silizium vorgesehen, die mit einer zweiten Platte aus Glas verbunden ist. Wenigstens eine der Platten weist auf ihrer, der anderen Platte zugewandten Oberfläche Kanalstrukturen auf. Bei Verbindung der Platten miteinander bilden diese Kanalstrukturen Gasführungsmittel.

Der Magnetfeldsensor ist bevorzugt in einem möglichst geringen Abstand zu den Gasführungsmitteln angeordnet. Bevorzugt ist der Magnetfeldsensor in einem Abstand von nicht mehr als 1 mm, insbesondere in einem Abstand von nicht mehr als 500 µm oder von nicht mehr als 200 µm von den Gasführungsmitteln angeordnet. Der Magnetfeldsensor kann beispielsweise in einem Abstand zwischen 30 und 200 µm von den Gasführungsmitteln angeordnet sein. Eine entsprechend nahe Anordnung des Magnetfeldsensors im Bereich der Gasführungsmittel gewährleistet, dass eine durch das Gas hervorgerufene Änderung des Magnetfeldes sicher durch den Magnetfeldsensor detektiert werden kann.

Soweit die Gasführungsmittel, wie oben ausgeführt, in einem Plattenstapel angeordnet sind, kann beispielsweise vorgesehen sein, dass der Magnetfeldsensor auf oder in einer der Platten, möglichst nahe an den Gasführungsmitteln, angeordnet ist, beispielsweise auf eine der Platten aufgeklebt ist.

Die Magnetfelderzeugungsmittel können erfindungsgemäß beliebige aus dem Stand der Technik bekannte Mittel sein, durch die ein Magnetfeld erzeugbar ist, insbesondere also beispielsweise Magnete. Die Komponente kann erfingdungsgemäß Magnetfelderzeugungsmitteln in Form von wenigstens einem der folgenden Mittel aufweisen: einen Permanentmagneten, einen Elektromagneten oder Kombinationen aus jeweils einem oder mehreren dieser Magneten.

Der oder die Permanentmagneten bestehen bevorzugt aus Elementen der seltenen Erden. Magnetfelderzeugungsmittel in Form von Permanentmagneten können insbesondere in Form eines Permanentmagnetenpaares vorgesehen sein, wobei zwischen einem Permanentmagnetenpaar beispielsweise zumindest bereichsweise ein homogenes Magnetfeldes erzeugbar sein kann, durch das das Gas mittels der Gaszuführungsmittel leitbar ist und in dem wenigstens einer der vorbezeichneten Magnetfeldsensoren angeordnet ist. Magnetfelderzeugungsmittel in Form von Permanentmagneten haben den besonderen Vorteil eines einfachen Aufbaus und einer besonders hohen Robustheit.

Elektromagneten können bevorzugt in Form stromdurchfließbarer Spulen, bevorzugt mit einem ferromagnetischen Kern vorgesehen sein. Magnetfelderzeugungsmittel in Form von Elektromagneten haben den besonderen Vorteil, dass durch diese das Magnetfeld modulierbar ist. Magnetfeldmessungen mit Hilfe eines modulierten Magnetfeldes sind aus dem stand der Technik bekannt. Bekanntermaßen weisen die durch ein moduliertes Magnetfeld empfangenen Signale des Magnetfeldsensors ein reduziertes Rauschen auf. Dies ermöglicht eine besonders empfindliche und genaue Bestimmung des Sauerstoffanteils in dem Gas mit der erfindungsgemäßen Komponente. Entsprechend können erfindungsgemäß Magnetfelderzeugungsmittel vorgesehen sein, durch die ein modulierbares Magnetfeld erzeugbar ist.

Alternativ oder kumulativ kann anstelle der Modulation des Magnetfeldes die Komponente wenigstens eine Heizeinrichtung zur thermischen Modulation des Gases aufweisen. Eine solche Heizeinrichtung nutzt die Temperaturabhangigkeit des Paramagnetismus aus. Auch durch eine Heizeinrichtung kann daher ein reduziertes Rauschen des vom Magnetfeldsensor empfangenen Signals erreicht werden, was ebenfalls eine besonders empfindliche und genaue Bestimmung des Sauerstoffanteils ermöglicht.

Erfindungsgemäß kann demnach wenigstens eine Heizeinrichtung vorgesehen sein, mittels derer das Gas thermisch beaufschlagbar, insbesondere modulierbar ist.

Erfindungsgemäß kann die Komponente auch wenigstens einen Strömungsmesser zur Messung der Strömung des durch die Gasführungsmittel strömenden beziehungsweise leitbaren Gases aufweisen. Ein solcher Strömungssensor kann insbesondere in Form eines Widerstandsthermometers, bevorzugt in Form eines Platin-Dünnschicht-Thermanemometers vorgesehen sein.

Zur Reduzierung externer Störeinflüsse kann die Komponente eine Abschirmung aufweisen, insbesondere eine Abschirmung gegen externe elektrische und/oder magnetische Felder. Es kann vorgesehen sein, dass diese Abschirmung allein die Magnetfeldsensoren abschirmt. Bevorzugt ist die Abschirmung jedoch um die Komponente herum angeordnet und kann beispielsweise als Gehäuse für die Komponente ausgebildet sein. Bevorzugt besteht die Abschirmung aus einem Metall oder einer Metall-Legierung, bevorzugt aus einer weichmagnetischen Nickel-Eisen-Legierung hoher magnetischer Permeabilität, beispielsweise aus einem Mu-Metall.

Gegenstand der Erfindung ist ferner eine Vorrichtung zur Bestimmung des Anteils an Sauerstoff in einem Gas, die wenigstens eine Komponente der vorbeschriebenen Art aufweist. Die Vorrichtung kann insbesondere auch eines oder mehrere der folgenden Mittel aufweisen: Mittel zur Messung des elektrischen Widerstandes des oder der Magnetfeldsensoren, Mittel zur Bestimmung der Änderung des Widerstandes des oder der Magnetfeldsensoren, Mittel zur Bestimmung des Anteils an Sauerstoff in dem Gas in Abhängigkeit von der gemessenen Änderung des elektrischen Widerstandes des Magnetfeldsensors (insbesondere beispielsweise eine entsprechende Auswertelektronik), oder Mittel zur Zu- und Ableitung von Gas zu und von den Gasführungsmitteln. Für diese Mittel kann auf die aus dem betreffenden Stand der Technik bekannten Mittel zurückgegriffen werden.

Die erfindungsgemäße Komponente kann beispielsweise als Steckeinheit ausgebildet sein und beispielsweise durch ein einfaches Einstecken in eine Vorrichtung zur Bestimmung des Anteils an Sauerstoff in einem Gas integrierbar sein.

Gegenstand der Erfindung sind ferner die Verwendung eines Magnetfeldsensors zur Bestimmung des Anteils an Sauerstoff in einem Gas sowie ein Verfahren zur Bestimmung des Anteils an Sauerstoff in einem Gas gemäß den Ansprüchen 5 und 6.

Bei der erfindungsgemäßen Verwendung sowie dem erfindungsgemäben Verfahren können diese mit den oben zur Komponente und Vorrichtung erläuterten Merkmalen der Erfindung erfolgen beziehungsweise durchgeführt werden.

Ein Ausführungsbeispiel einer erfindungsgemäßen Komponente soll anhand der nachfolgenden Figurenbeschreibung näher erläutert werden.

Dabei zeigt, jeweils in schematischer Ausführung stark vereinfacht dargestellt,
- Figur 1: eine Aufsicht auf eine Komponente,
- Figur 2: die Darstellung gemäß Figur 1, jedoch mit entferntem Permanentmagneten,
- Figur 3: eine Schnittansicht auf die Schnittfläche entlang der Schnittlinie A-A gemäß Figur 1 von rechts,
- Figur 4: eine Schnittansicht auf die Schnittfläche entlang der Schnittlinie B-B gemäß Figur 3 von oben und
- Figur 5: eine schematische Darstellung einer Vorrichtung mit einer darin integrierten Komponente.

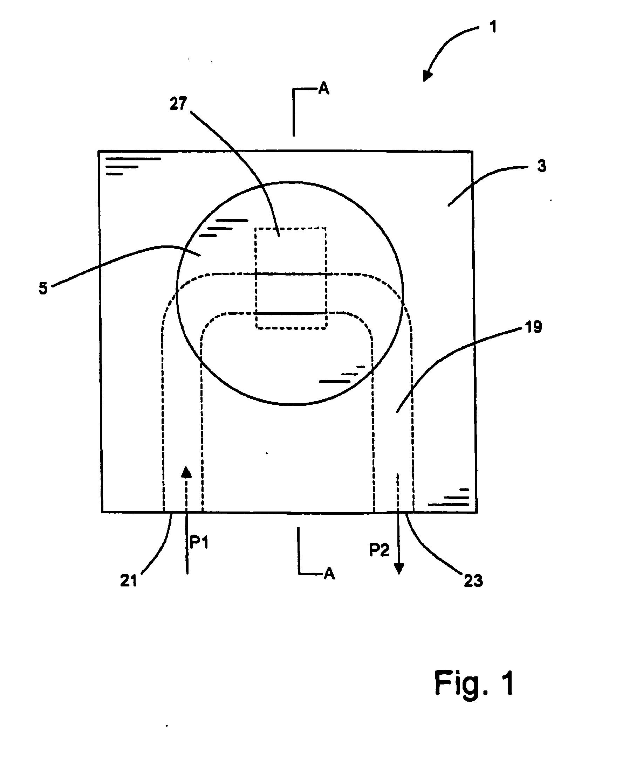

In der Darstellung nach Figur 1 ist die Komponente in ihrer Gesamtheit mit dem Bezugszeichen 1 gekennzeichnet. Die Komponente 1 weist einen Stapel aus Platten diamagnetischer Materialien auf, in die Kanalstrukturen zur Ausbildung von Gasführungsmitteln eingebracht sind. In der Darstellung nach Figur 1 sind eine außenliegende Platte 3 des Plattenstapels sowie ein auf dieser außenliegenden Platte 3 angeordneter Permanentmagnet 5 dargestellt.

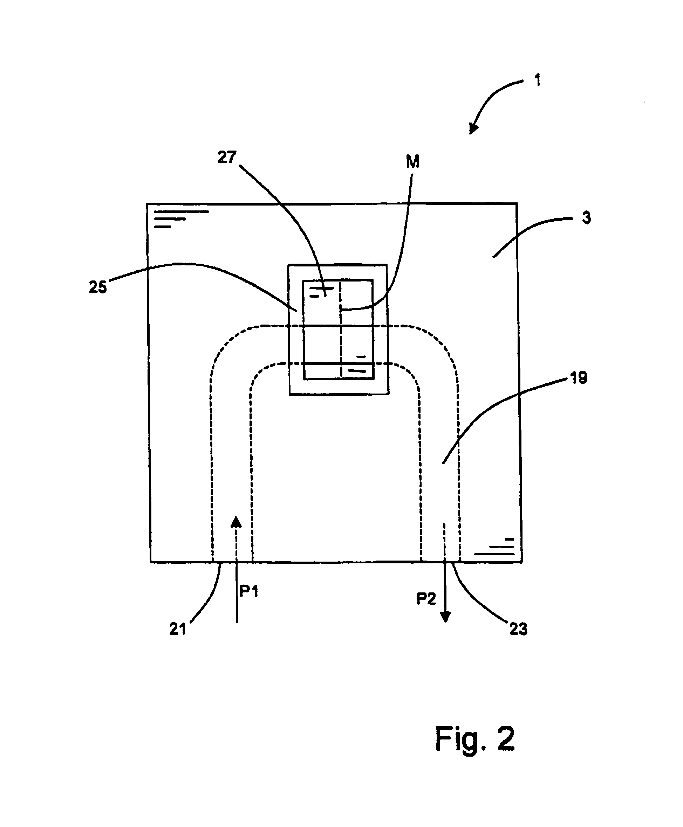

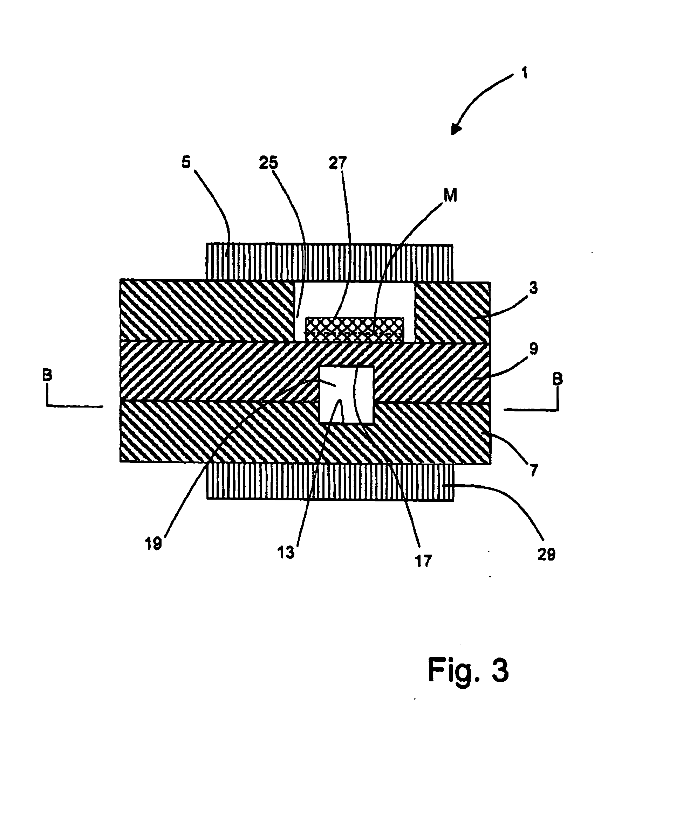

Der Plattenstapel ist insbesondere in Figur 3 gut zu erkennen. Er besteht aus einer ersten Platte 7 aus Silizium, einer auf dieser angeordneten, zweiten Platte 9 aus Glas sowie einer wiederum auf dieser Platte angeordneten dritten Platte 3 aus Silizium. Die drei Platten 7, 9 und 3 weisen jeweils einen rechteckigen Außenumfang auf und sind mit ihren Außenkanten bündig übereinander angeordnet. In der Siliziumplatte 7 ist eine erste Kanalstruktur 13 und in der auf dieser Siliziumplatte 7 angeordneten Platte 9 eine zweite Kanalstruktur 15 derart angeordnet, dass diese Kanalstrukturen 13, 15 gemeinsam Gasführungsmittel in Form einer Gasleitung 19 mit rechteckigem Querschnitt bilden. Die Gasleitung 19 weist einen im Wesentlichen U-förmigen Verlauf mit einem Gaseinlass 21 und einem Gasauslass 23 auf derselben Seite der Vorrichtung 1 auf. Der Verlauf der Gasleitung 19 in der Komponente 1 ist in den Figuren 1 und 2 durch gestrichelte Linien dargestellt. Die auf der zweiten Platte 9 aus Glas angeordnete dritte Platte 3 aus Silizium weist eine Öffnung 25 auf, so dass die zweite Platte 9 im Bereich dieser Öffnung 25 nicht durch die dritte Platte 3 abgedeckt ist.

Im Bereich der Öffnung 25 ist ein Magnetfeldsensor in Form eines AMR-Magnetfeldsensors 27 auf der zweiten Platte 9 angeordnet. Dieser AMR-Magnetfeldsensor 27 ist in einem Abstand von 0,1 mm von der Gasleitung 19 angeordnet. Dieser Abstand von 0,1 mm entspricht der verbliebenen Dicke der zweiten Platte 9 zwischen dem Grund der Kanalstruktur 17 und der Außenseite der zweiten Platte 9, auf der der AMR-Magnetfeldsensor 27 angeordnet ist.

Außenseitig ist ein Permanentmagnetenpaar an dem Stapel aus den drei Platten 7, 9 und 3 angeordnet. Dabei ist ein erster Permanentmagnet 5 auf der Außenseite der dritten Platte 3 und ein zweiter Permanentmagnet 29 auf der Außenseite der ersten Platte 7 angeordnet. Die Permanentmagneten 5, 29 weisen jeweils eine Scheibenform mit einem kreisförmigen Außenumfang auf. Das Permanentmagnetenpaar 5, 29 erzeugt in dem zwischen ihnen liegenden Bereich, in dem der AMR-Magnetfeldsensor 27 angeordnet ist, ein homogenes Magnetfeld, dessen magnetische Flussdichte keine Komponente in Richtung der empfindlichen Achse des AMR-Magnetfeldsensors 27 aufweist. Dabei ist die Feldrichtung des Magnetfeldes senkrecht zur empfindlichen Achse des AMR-Magnetfeldsensors 27 angeordnet.

Die empfindliche Achse des AMR-Magnetfeldsensors 27 verläuft in der Ansicht gemäß Figur 3 in der Zeichenebene und ist durch die mit dem Bezugszeichen M versehene, gestrichelte Linie angedeutet. Die Richtung des Magnetfeldes beziehungsweise der magnetischen Flussdichte des Magnetfeldes zwischen dem Permanentmagnetenpaar 5, 29 verläuft gemäß Figur 3 parallel zur Zeichenebene von oben nach unten. In der Darstellung gemäß den Figuren 1, 2 und 4 ist die Feldrichtung beziehungsweise die Richtung des magnetischen Flusses des Magnetfeldes zwischen dem Permanentmagnetenpaar 5, 29 damit senkrecht zur Zeichenebene.

Das durch das Permanentmagnetenpaar 5, 29 erzeugbare Magnetfeld weist in dem zwischen ihnen liegenden Bereich, in dem auch der AMR-Magnetfeldsensor 27 angeordnet ist, eine Stärke von 10 mT auf. Der AMR-Magnetfeldsensor 27 ist als Vollbrücke ausgebildet und weist eine Empfindlichkeit beziehungsweise ein messbares Signal im Bereich von > 0 bis 10 nT auf.

Wie in den Figuren 1 bis 4 zu erkennen, sind - in Richtung der empfindlichen Achse M des AMR-Magnetfeldsensors 27 betrachtet - das Magnetfeld, der Gaskanal 19 und der AMR-Magnetfeldsensor 27 asymmetrisch zueinander angeordnet.

Figur 2 zeigt die Komponente 1 in der Ansicht gemäß Figur 1, jedoch mit entferntem Permanentmagneten 5. Hierdurch ist die ansonsten von dem Permanentmagneten 5 verdeckte Öffnung 25 mit dem darin angeordneten AMR-Magnetfeldsensor 27 zu erkennen.

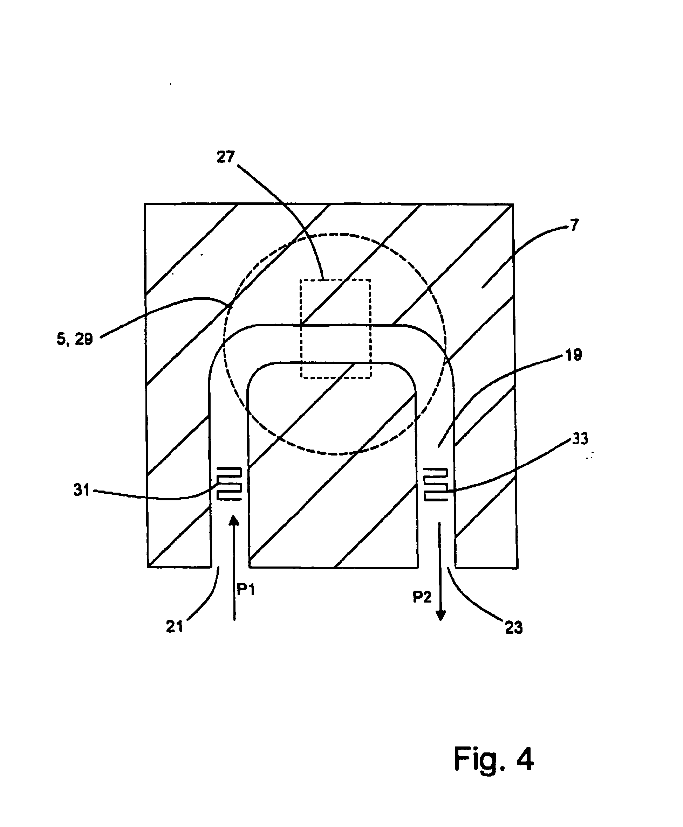

Schließlich zeigt die Darstellung nach Figur 4 eine Schnittansicht auf die Schnittfläche entlang der Schnittlinie B-B gemäß Figur 3 von oben. Gut zu erkennen ist der U-förmige Verlauf der Gasleitung 19 im Bereich der ersten Platte 7. Die Gasleitung 19 weist einen Gaseinlass 21 auf, durch den Gas in Pfeilrichtung P1 in den ersten Schenkel der Gasleitung 19 einleitbar ist. Benachbart zum Gaseinlass 21 ist eine Heizeinrichtung 31 in der Gasleitung 19 angeordnet, durch die das Gas thermisch modulierbar ist. Die Gasleitung geht anschließend in den mittleren Abschnitt der Gasleitung über, wobei dieser Abschnitt durch den Bereich des durch das Permanentmagnetenpaar 5, 29 erzeugten Magnetfeldes und am AMR-Magnetfeldsensor 27 vorbei führt. Die Gasleitung 19 geht schließlich in ihren zweiten Schenkel über. In diesem Abschnitt der Gasleitung 19 wird das Gas noch an einem in der Gasleitung 19 angeordneten Strömungsmesser 33 in Form eines Platin-Dünnschicht-Thermoanemometers vorbeigeführt und verlässt die Gasleitung 19 anschließend in Pfeilrichtung P2 durch den Gasauslass 23. Die Lage der Permanentmagnete 5, 29 sowie des AMR-Magnetfeldsensors 27 sind in Figur 4 durch gestrichelte Linien angedeutet.

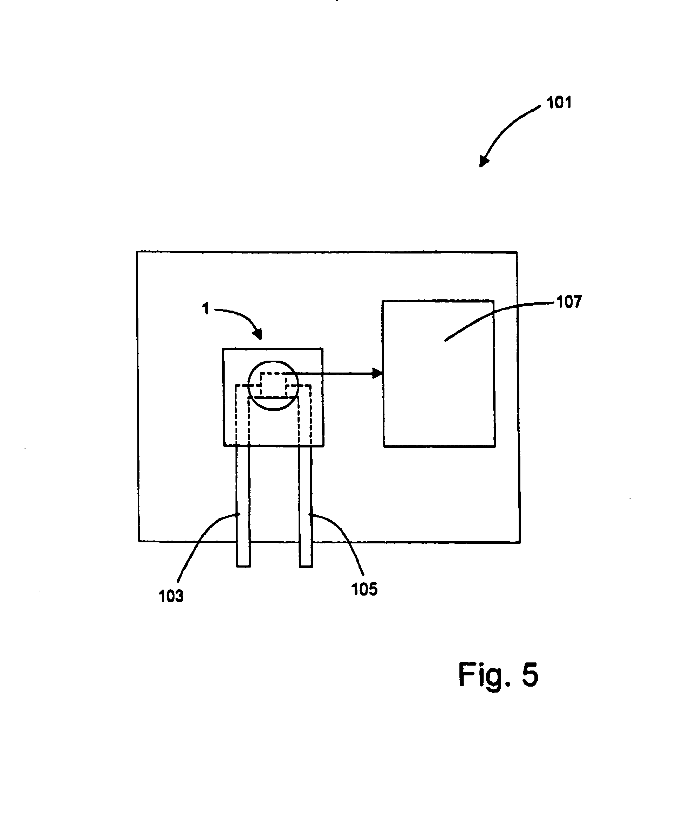

Die schematische Darstellung nach Figur 5 zeigt eine Vorrichtung 101 zur Bestimmung des Anteils an Sauerstoff in einem Gas mit einer darin integrierten Komponente 1. Die Vorrichtung 101 weist eine an den Gaseinlass 21 der Komponente 1 koppelbare Gaszuführleitung 103 und eine an den Gasauslass 23 der Komponente 1 koppelbare Gasabführleitung 105 auf. Ferner weist die Vorrichtung 101 eine Mess- und Auswertelektronik 107 auf, mittels derer der elektrische Widerstand des AMR-Magnetfeldsensors 27 messbar und ein sich danach ergebender Sauerstoffanteil in dem durch die Gasleitung 19 geleiteten Gas bestimmbar ist.

Die Komponente 1 gemäß dem dargestellten Ausführungsbeispiel funktioniert wie folgt.

Gas wird durch den Gaseinlass 21 in die Gasleitung 19 eingeleitet und in dieser durch die Komponente 1 geleitet, bis es die Gasleitung 19 beim Gasauslass 23 wieder verlässt.

Soweit und solange das durch die Gasleitung 19 geleitete Gas keine Anteile an Sauerstoff aufweist, wird das zwischen den Permanentmagneten 5, 29 erzeugte Magnetfeld durch das Gas nicht verändert (Nullstellung).

Weist das durch die Gasleitung 19 geleitete Gas jedoch Anteile an Sauerstoff auf, wird das zwischen den Permanentmagneten 5, 29 erzeugte Magnetfeld verändert. Im vorliegenden Fall wird die Richtung der magnetischen Flussdichte des Magnetfeldes, deren Richtung in der Nullstellung im Wesentlichen senkrecht zur empfindlichen Achse M des AMR-Magnetfeldsensors 27 verlief, durch den Sauerstoff derart verändert, dass die Richtung der magnetischen Flussdichte nunmehr auch eine Komponente aufweist, die in Richtung der empfindlichen Achse M des AMR-Magnetfeldsensors 27 verläuft. Hierdurch ändert sich der elektrische Widerstand des AMR-Magnetfeldsensors 27.

Diese Widerstandsänderung ist durch die Mess- und Auswertelektronik 107 der Vorrichtung 101 messbar und der sich danach ergebende Anteil an Sauerstoff in dem Gas in Abhängigkeit von dieser gemessenen Änderung des elektrischen Widerstandes bestimmbar.

Kumulativ kann vorgesehen sein, das Gas durch die Heizeinrichtung 31 thermisch zu regulieren, wodurch das Rauschen des Messsignales reduziert und eine noch genauere Messung des Anteils an Sauerstoff in dem Gas vorgenommen werden kann.

Ferner kann die Strömungsgeschwindigkeit des Gases durch den Strömungsmesser 33 gemessen werden.

## Patentansprüche

1. Komponente für eine Vorrichtung zur Bestimmung des Anteils an Sauerstoff in einem Gas mit folgenden Merkmalen:
Magnetfelderzeugungsmitteln (5, 29), durch die ein Magnetfeld erzeugbar ist;
Gasführungsmitteln (19) aus diamagnetischem Material, mittels derer das Gas durch das erzeugbare Magnetfeld leitbar ist;
wenigstens einem Magnetfeldsensor in Form eines als Vollbrücke ausgebildeten AMR-Magnetfeldsensors (27) oder TMR-Magnetfeldsensors, der derart in dem erzeugbaren Magnetfeld angeordnet ist, dass eine mittels Leitung des Gases durch das Magnetfeld hervorgerufene Änderung des Magnetfeldes zu einer Änderungen des Widerstandes des Magnetfeldsensors führt;
wobei durch die Magnetfelderzeugungsmittel (5, 29) ein Magnetfeld erzeugbar ist, das im Wesentlichen keine magnetische Flussdichte in Richtung der empfindlichen Achse (M) des AMR-Magnetfeldsensors (27) oder TMR-Magnetfeldsensors aufweist.

2. Komponente nach Anspruch 1, bei der durch die Magnetfelderzeugungsmittel (5, 29) wenigstens im Bereich des Magnetfeldsensors ein homogenes Magnetfeld erzeugbar ist.

3. Komponente nach Anspruch 1, bei der der Magnetfeldsensor in einem Abstand von nicht mehr als 1 mm von den Gasführungsmitteln (19) angeordnet ist.

4. Vorrichtung (101) zur Bestimmung des Anteils an Sauerstoff in einem Gas mit einer Komponente nach Anspruch 1.

5. Verwendung wenigstens eines Magnetfeldsensors zur Bestimmung des Anteils an Sauerstoff in einem Gas, wobei
ein Magnetfeld erzeugt wird,
Gas mittels Gasführungsmitteln (19) aus diamagnetischem Material durch das Magnetfeld geleitet wird, der
wenigstens eine Magnetfeldsensor in Form eines als Vollbrücke ausgebildeten AMR-Magnetfeldsensors (27) oder TMR-Magnetfeldsensors derart in dem erzeugbaren Magnetfeld angeordnet wird, dass eine mittels Leitung des Gases durch das Magnetfeld hervorgerufene Änderung des Magnetfeldes zu einer Änderung des Widerstandes des Magnetfeldsensors führt;
durch die Magnetfelderzeugungsmittel (5, 29) ein Magnetfeld erzeugt wird, das im Wesentlichen keine magnetische Flussdichte in Richtung der empfindlichen Achse (M) des AMR-Magnetfeldsensors (27) oder TMR-Magnetfeldsensors aufweist;
das Magnetfeld durch einen Anteil an Sauerstoff, den das Gas aufweist, verändert wird,
die Änderung des elektrischen Widerstand des Magnetfeldsensors, die dieser aufgrund der Änderung des Magnetfeldes erfährt, gemessen wird,
der Anteil an Sauerstoff in dem Gas in Abhängigkeit von der gemessenen Änderung des elektrischen Widerstandes des Magnetfeldsensors (27) bestimmt wird.

6. Verfahren zur Bestimmung des Anteils an Sauerstoff in einem Gas, bei dem
ein Magnetfeld erzeugt wird,
Gas mittels Gasführungsmitteln (19) aus diamagnetischem Material durch das Magnetfeld geleitet wird,
wenigstens ein Magnetfeldsensor in Form eines als Vollbrücke ausgebildeten AMR-Magnetfeldsensors (27) oder TMR-Magnetfeldsensors derart in dem erzeugbaren Magnetfeld angeordnet wird, dass eine mittels Leitung des Gases durch das Magnetfeld hervorgerufene Änderung des Magnetfeldes zu einer Änderung des Widerstandes des Magnetfeldsensors führt;
durch die Magnetfelderzeugungsmittel (5, 29) ein Magnetfeld erzeugt wird, das im Wesentlichen keine magnetische Flussdichte in Richtung der empfindlichen Achse (M) des AMR-Magnetfeldsensors (27) oder TMR-Magnetfeldsensors aufweist;
das Magnetfeld durch einen Anteil an Sauerstoff, den das Gas aufweist, verändert wird,
die Änderung des elektrischen Widerstand des Magnetfeldsensors, die dieser aufgrund der Änderung des Magnetfeldes erfährt, gemessen wird,
der Anteil an Sauerstoff in dem Gas in Abhängigkeit von der gemessenen Änderung des elektrischen Widerstandes des Magnetfeldsensors (27) bestimmt wird.

## Claims

1. A component for a device for determining the proportion of oxygen in a gas having the following features:
magnetic field producing means (5, 29) with which a magnetic field can be produced;
gas conveying means (19) made from diamagnetic material, by means of which the gas can be conducted through the magnetic field that can be produced;
at least one magnetic field sensor in the form of an AMR magnetic field sensor (27) or TMR magnetic field sensor designed as a full bridge, which is disposed in the magnetic field that can be produced in such a manner that a change in the magnetic field caused by conducting the gas through the magnetic field leads to a change in the resistance of the magnetic field sensor;
wherein a magnetic field can be produced by the magnetic field producing means (5, 29), which essentially exhibits no magnetic flux density in the direction of the sensitive axis (M) of the AMR magnetic field sensor (27) or the TMR magnetic field sensor.

2. The component according to claim 1, in which a homogeneous magnetic field can be produced by the magnetic field producing means (5, 29), at least in the region of the magnetic field sensor.

3. The component according to claim 1, in which the magnetic field sensor is disposed at a distance of no more than 1 mm from the gas conveying means (19).

4. A device (101) for determining the proportion of oxygen in a gas with a component according to claim 1.

5. The use of at least one magnetic field sensor to determine the proportion of oxygen in a gas, wherein
a magnetic field is produced,
gas is conducted through the magnetic field by means of gas conveying means (19) made of diamagnetic material,
the at least one magnetic field sensor in the form of an AMR magnetic field sensor (27) or TMR magnetic field sensor designed as a full bridge is disposed in the magnetic field that can be produced in such a manner that a change in the magnetic field caused by conducting the gas through the magnetic field leads to a change in the resistance of the magnetic field sensor;
a magnetic field is produced by the magnetic field producing means (5, 29), which essentially exhibits no magnetic flux density in the direction of the sensitive axis (M) of the AMR magnetic field sensor (27) or the TMR magnetic field sensor;
the magnetic field is changed by a proportion of oxygen in the gas,
the change in the electrical resistance of the magnetic field sensor experienced by the latter due to the change in the magnetic field is measured,
the proportion of oxygen in the gas is determined depending on the measured change in the electrical resistance of the magnetic field sensor (27).

6. The method of determining the proportion of oxygen in a gas, in which
a magnetic field is produced,
gas is conducted through the magnetic field by means of gas conducting means (19) made from diamagnetic material,
at least one magnetic field sensor in the form of an AMR magnetic field sensor (27) or TMR magnetic field sensor designed as a full bridge is disposed in the magnetic field that can be produced in such a manner that a change in the magnetic field caused by conducting the gas through the magnetic field leads to a change in the resistance in the magnetic field sensor;
a magnetic field is produced by the magnetic field producing means (5, 29), which essentially exhibits no magnetic flux density in the direction of the sensitive axis (M) of the AMR magnetic field sensor (27) or the TMR magnetic field sensor;
the magnetic field is changed by a proportion of oxygen in the gas,
the change in the electrical resistance of the magnetic field sensor experienced by the latter due to the change in the magnetic field is measured,
the proportion of oxygen in the gas is determined depending on the measured change in the electrical resistance of the magnetic field sensor (27).

## Revendications

1. Composant pour un dispositif destiné à déterminer la fraction d'oxygène dans un gaz et présentant les caractéristiques suivantes :
des moyens de génération de champ magnétique (5, 29) par lesquels un champ magnétique peut être généré ;
des moyens de guidage de gaz (19) à base de matériau diamagnétique, qui permettent de guider le gaz à travers le champ magnétique pouvant être généré ;
au moins un capteur de champ magnétique sous forme d'un capteur de champ magnétique AMR (27) ou d'un capteur de champ magnétique TMR, conçu comme pont intégral, qui est disposé dans le champ magnétique pouvant être généré de telle sorte qu'une variation du champ magnétique, qui est causée au moyen du guidage du gaz à travers le champ magnétique, entraîne une variation de la résistance du capteur de champ magnétique ;
un champ magnétique pouvant être généré par les moyens de génération de champ magnétique (5, 29), lequel champ ne présente sensiblement pas de densité de flux magnétique en direction de l'axe (M) sensible du capteur de champ magnétique AMR (27) ou du capteur de champ magnétique TMR.

2. Composant selon la revendication 1, sur lequel un champ magnétique homogène peut être généré par les moyens de génération de champ magnétique (5, 29) au moins dans la zone du capteur de champ magnétique.

3. Composant selon la revendication 1, sur lequel le capteur de champ magnétique est disposé à une distance de pas plus de 1 mm des moyens de guidage de gaz (19).

4. Dispositif (101) destiné à déterminer la fraction d'oxygène dans un gaz avec un composant selon la revendication 1.

5. Utilisation d'au moins un capteur de champ magnétique pour déterminer la fraction d'oxygène dans un gaz, dans laquelle
un champ magnétique étant généré,
du gaz étant dirigé à travers le champ magnétique à l'aide de moyens de guidage de gaz (19) à base de matériau-diamagnétique,
au moins un capteur de champ magnétique se présentant sous la forme d'un capteur de champ magnétique AMR (27) ou d'un capteur de champ magnétique TMR, conçu comme pont intégral, étant disposé dans le champ magnétique pouvant être généré de telle sorte qu'une variation du champ magnétique, qui est causée par le guidage du gaz à travers le champ magnétique, entraîne une variation de la résistance du capteur de champ magnétique ;
un champ magnétique étant généré par les moyens de génération de champ magnétique (5, 29), lequel champ ne présente sensiblement pas de densité de flux magnétique en direction de l'axe (M) fragile du capteur de champ magnétique AMR (27) ou du capteur de champ magnétique TMR ;
le champ magnétique étant modifié par une fraction d'oxygène que le gaz présente,
la variation de la résistance électrique du capteur du champ magnétique, que celui-ci subit du fait de la variation du champ magnétique, étant mesurée,
la fraction d'oxygène dans le gaz est déterminée en fonction de la variation mesurée de la résistance électrique du capteur de champ magnétique (27).

6. Procédé pour déterminer la fraction d'oxygène dans un gaz, dans lequel
un champ magnétique est généré,
du gaz est dirigé à travers le champ magnétique à l'aide de moyens de guidage de gaz (19) à base de matériau diamagnétique,
au moins un capteur de champ magnétique se présentant sous la forme d'un capteur de champ magnétique AMR (27) ou d'un capteur de champ magnétique TMR, conçu comme pont intégral, est disposé dans le champ magnétique pouvant être généré de telle sorte qu'une variation du champ magnétique, qui est causée par le guidage du gaz à travers le champ magnétique, entraîne une variation de la résistance du capteur de champ magnétique ;
un champ magnétique est généré par les moyens de génération de champ magnétique (5, 29), lequel champ ne présente sensiblement pas de densité de flux magnétique en direction de l'axe (M) sensible du capteur de champ magnétique AMR (27) ou du capteur de champ magnétique TMR ;
le champ magnétique est modifié par une fraction d'oxygène que le gaz présente
la variation de la résistance électrique du capteur du champ magnétique, que celle-ci subit en raison de la variation du champ magnétique, est mesurée,
la fraction d'oxygène dans le gaz est déterminée en fonction de la variation mesurée de la résistance électrique du capteur de champ magnétique (27).
